# EUROPÄISCHE PATENTANMELDUNG

(11) **EP 2 899 888 A1**
(43) Veröffentlichungstag der Anmeldung: **29.07.2015**
(21) Anmeldenummer: 15152247.1
(22) Anmeldetag: 23.01.2015
(51) Int. Cl.: H03M 1/36, H03M 1/58

(54) **Elektrischer A/D Wandler**

(30) Priorität: 28.01.2014 DE 102014100990
(71) Anmelder: Phoenix Contact GmbH & Co. KG, 32825 Blomberg (DE)
(72) Erfinder: Walter, Thomas, 31812 Bad Pyrmont (DE); Benk, Stefan, 31812 Bad Pyrmont (DE)
(74) Vertreter: Klinski, Robert

(57) **Zusammenfassung**

Die vorliegende Erfindung betrifft einen elektrischer Wandler (100) zum Wandeln eines analogen Eingabewertes in eine digitalen Ausgabewert, mit einem Referenzwerterzeuger (101) zum Erzeugen einer Anzahl von Referenzwerten mit einem nichtlinearen Verlauf; und einem Vergleicher (103) zum Vergleichen eines Referenzwertes aus der Anzahl von Referenzwerten mit dem analogen Eingabewert, um den digitalen Ausgabewert zu erzeugen.

## Beschreibung

Die vorliegende Erfindung betrifft einen elektrischer Wandler zum Wandeln eines analogen Eingabewertes in einen digitalen Ausgabewert.

Bei der Wandlung einer analogen Größe kann diese gegen ein linear verlaufendes Referenzsignal verglichen werden. Beim sog. Single-Slope- oder auch Sägezahn-Verfahren ist die Zeit, die vergeht, bis das über die Zeit linear ansteigende Referenzsignal einen Bereich von einem definierten Startpunkt bis zum Überschreiten des zu wandelnden Signals überstrichen hat, proportional zur zu wandelnden Größe. Bei Flash-AD-Wandlern wird die lineare Referenz durch Aufteilung einer Referenzspannung über ein Widerstandsarray mit gleichen Widerständen realisiert.

Je nach Anwendung sind diese Verfahren nicht optimal. So stehen beispielsweise beim Single-Slope-Verfahren Messgeschwindigkeit und Genauigkeit zueinander in Konkurrenz. Beim Flash-ADC existiert analog dazu das Spannungsverhältnis von Auflösung/Genauigkeit und Anzahl der Vergleicherstufen.

Die Druckschrift JP 2012-100261 A beschreibt beispielsweise einen Analog-Digital-Wandler mit einem Rampenerzeuger zum Erzeugen eines linear ansteigenden Referenzsignals.

Es ist die der Erfindung zugrundeliegende Aufgabe, einen Wandler mit geringer Umwandlungszeit und einer hohen Genauigkeit anzugeben.

Diese Aufgabe wird durch Gegenstände mit den Merkmalen nach den unabhängigen Ansprüchen gelöst. Vorteilhafte Ausführungsformen der Erfindung sind Gegenstand der Figuren, der Beschreibung und der abhängigen Ansprüche.

Gemäß einem ersten Aspekt der Erfindung wird die Aufgabe durch einen elektrischen Wandler zum Wandeln eines analogen Eingabewertes in eine digitalen Ausgabewert gelöst, mit einem Referenzwerterzeuger zum Erzeugen einer Anzahl von Referenzwerten mit einem nichtlinearen Verlauf; und einem Vergleicher zum Vergleichen eines Referenzwertes aus der Anzahl von Referenzwerten mit dem analogen Eingabewert, um den digitalen Ausgabewert zu erzeugen. Dadurch wird beispielsweise der technische Vorteil erreicht, dass auf eine vorangestellte Filtereinheit verzichtet werden kann, die eine Wandlungszeit verschlechtert. Zusätzlich kann der Bauteilbedarf reduziert werden.

In einer vorteilhaften Ausführungsform des Wandlers ist der Referenzwerterzeuger ausgebildet, einen zeitlich nichtlinearen Spannungsverlauf zu erzeugen. Dadurch wird beispielsweise der technische Vorteil erreicht, dass durch den Wandler ein Spannungswert digitalisiert werden kann.

In einer weiteren vorteilhaften Ausführungsform des Wandlers ist der Referenzwerterzeuger ausgebildet, einen nicht-monotonen Spannungsverlauf zu erzeugen. Dadurch wird beispielsweise der technische Vorteil erreicht, dass zunächst ein grober Messwert bestimmt wird, der anschließend nochmals in genauerer Weise bestimmt wird.

In einer weiteren vorteilhaften Ausführungsform des Wandlers ist der Referenzwerterzeuger ausgebildet, einen nichtlinearen Spannungsverlauf aus zeitlich abschnittsweise linearen Spannungsverläufen zu erzeugen. Dadurch wird beispielsweise der technische Vorteil erreicht, dass je nach Genauigkeit und Schnelligkeit der Messung ein speziell angepasster linearer Spannungsverlauf verwendet werden kann.

In einer weiteren vorteilhaften Ausführungsform des Wandlers weist ein linearer Spannungsverlauf eine niedrigere Steigung als ein vorangehender linearer Spannungsverlauf und ein nachfolgender Spannungsverlauf auf. Dadurch wird beispielsweise der technische Vorteil erreicht, dass im ersten und im dritten Bereich eine zeitoptimierte Messung und im zweiten Bereich eine auflösungsoptimierte Messung erfolgt.

In einer weiteren vorteilhaften Ausführungsform des Wandlers weist ein Vorzeichen einer Steigung eines linearen Spannungsverlaufs ein anderes Vorzeichen als eine Steigung eines vorangehenden linearen Spannungsverlaufs und eines nachfolgenden Spannungsverlaufs auf. Dadurch wird beispielsweise der technische Vorteil erreicht, dass ein bestimmter Bereich mehrfach überstrichen wird und sich die Genauigkeit eines Ausgabewertes im mehrfach überstrichenen Bereich verbessert.

In einer weiteren vorteilhaften Ausführungsform des Wandlers umfasst der Referenzwerterzeuger mehrere zuschaltbare Stromblöcke. Dadurch wird beispielsweise der technische Vorteil erreicht, dass der Spannungsverlauf auf einfache Weise erzeugt werden kann.

In einer weiteren vorteilhaften Ausführungsform des Wandlers sind die Stromblöcke gemäß einem Eingangssignal zuschaltbar. Dadurch wird beispielsweise der technische Vorteil erreicht, dass ein beliebiger Spannungsverlauf erzeugbar ist.

In einer weiteren vorteilhaften Ausführungsform des Wandlers ist der Ausgang der Stromblöcke mit einem Kondensator verbunden. Dadurch wird beispielsweise der technische Vorteil erreicht, dass der von den Stromblöcken zugeführte Strom in eine Spannung umgewandelt wird.

In einer weiteren vorteilhaften Ausführungsform des Wandlers umfasst der Referenzwerterzeuger ein Widerstandsarray. Dadurch wird beispielsweise der technische Vorteil erreicht, dass sich gleichzeitig eine Anzahl von Referenzwerten erzeugen lässt.

In einer weiteren vorteilhaften Ausführungsform des Wandlers sind die Widerstände des Widerstandsarrays in Serie geschaltet. Dadurch wird beispielsweise der technische Vorteil erreicht, dass ein einfacher Aufbau des Referenzwerterzeugers realisiert wird.

In einer weiteren vorteilhaften Ausführungsform des Wandlers ist zwischen zwei Widerständen jeweils ein Vergleicher verbunden. Dadurch wird beispielsweise der technische Vorteil erreicht, dass sich eine Mehrzahl an Referenzwerten gleichzeitig vergleichen lässt.

Gemäß einem zweiten Aspekt der Erfindung wird die Aufgabe durch ein Verfahren zum Wandeln eines analogen Eingabewertes in eine digitalen Ausgabewert gelöst, mit den Schritten eines Erzeugens einer Anzahl von Referenzwerten mit einem nichtlinearen Verlauf durch einen Referenzwerterzeuger; und eines Vergleichens eines Referenzwertes aus der Anzahl von Referenzwerten mit dem analogen Eingabewert durch einen Vergleicher, um den digitalen Ausgabewert zu erzeugen. Dadurch werden beispielsweise die gleichen technischen Vorteile wie durch den Wandler nach dem ersten Aspekt erreicht.

In einer vorteilhaften Ausführungsform des Verfahrens ist der nicht lineare Verlauf ein zeitlich nichtlinearer Spannungsverlauf. Dadurch wird beispielsweise ebenfalls der technische Vorteil erreicht, dass ein Spannungswert digitalisiert werden kann.

In einer weiteren vorteilhaften Ausführungsform des Verfahrens ist der nicht lineare Verlauf ein nicht-monotoner Spannungsverlauf. Dadurch wird beispielsweise ebenfalls der technische Vorteil erreicht, dass zunächst ein grober Messwert bestimmt wird, der anschließend nochmals in genauerer Weise bestimmt wird.

Ausführungsbeispiele der Erfindung sind in den Zeichnungen dargestellt und werden im Folgenden näher beschrieben.

Es zeigen:
- Fig. 1: eine schematische Ansicht eines Wandlers;
- Fig. 2: eine Ansicht eines Widerstandsarrays;
- Fig. 3: einen Vergleicher in Kombination mit einer Auswertelogik;
- Fig. 4: eine Ansicht eines Referenzspannungserzeugers;
- Fig. 5A und 5B: eine Ansicht von nichtlinearen Spannungsverläufen; und
- Fig. 6: ein Blockdiagram eines Verfahrens.

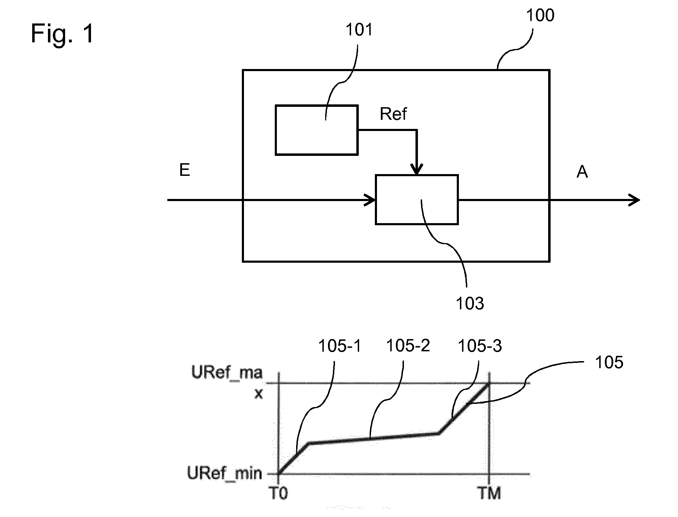

Fig. 1 zeigt eine schematische Ansicht eines Wandlers 100. Der elektrischer Wandler 100 dient zum Wandeln eines analogen Eingabewertes E in einen digitalen Ausgabewert A, mit einem Referenzwerterzeuger 101 zum Erzeugen einer Anzahl von Referenzwerten mit einem nichtlinearen Verlauf; und einem Vergleicher 103 zum Vergleichen eines Referenzwertes aus der Anzahl von Referenzwerten mit dem analogen Eingabewert, um den digitalen Ausgabewert zu erzeugen.

Durch den Referenzwerterzeuger 101 ist ein Referenzwertverlauf so in das Wandlerprinzip integriert, dass auf zusätzliche und vorangestellte Filtereinheiten verzichtet werden kann und der Bauteilbedarf reduziert wird. Daneben wird durch den nichtlinearen Verlauf der Referenzwerte die Wandlungszeit des Wandlers 100 verbessert.

Der Referenzwerterzeuger 101 erzeugt beispielsweise einen nichtlinearen Spannungsverlauf 105 in Abhängigkeit der Zeit als Referenzfunktion, der aus einzelnen linear verlaufenden Spannungsverläufen 105-1 bis 105- 3 zusammengesetzt ist. Dadurch lässt sich im Bereich der Spannungsverläufe 105-1 und 105-3 eine hohe Messgeschwindigkeit realisieren und im Bereich des Spannungsverlaufs 105-2 eine hohe Genauigkeit realisieren. Auf eine Kennlinienumformung kann somit verzichtet werden.

Der Spannungsverlauf 105 als Referenzfunktion kann durch eine geeignete Schaltung direkt erzeugt werden, so dass im Bereich der Spannungsverläufe 105-1 und 105- 3 eine zeitoptimierte und grobauflösende Messung und im Bereich des Spannungsverlaufs 105-2 eine auflösungsoptimierte Messung durchgeführt wird.

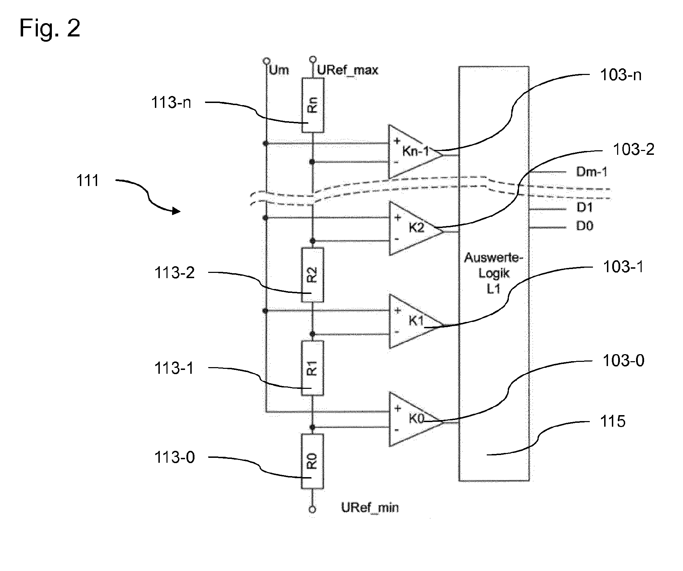

Fig. 2 zeigt eine Ansicht eines Widerstandsarrays 111 als Referenzwerterzeuger 101. Das Widerstandsarray ist mit unterschiedlichen und ungleichen Widerständen R0, ..., Rn aufgebaut, so dass an jedem Widerstand R0, ..., Rn eine andere Spannung abfällt. Dadurch ergibt sich eine Folge aus Referenzwerten mit einem nichtlinearen Verlauf. Auf diese Weise kann analog zum Referenzverlauf in Fig. 1 eine nichtlineare Referenz für dieses Wandel prinzip geschaffen werden. Jeder der durch einen der Widerstände R0, ..., Rn erzeugten Spannungsabfälle wird mit einem Vergleicher 103-0, ..., 103-n mit dem Eingabewert verglichen, wie beispielsweise einer Spannung Um. Die Ergebnisse des jeweiligen Vergleichs werden an eine Auswertelogik 115 geliefert.

Dadurch entsteht der Vorteil, dass jede beliebige streng monotone Referenzkennlinie mittels der Widerstände R0, ..., Rn rein Ohm'sch und auf einfache Weise realisiert werden kann. Dies gilt auch, wenn exponentielle oder logarithmische Verläufe auch nur abschnittsweise gewünscht sind. Dadurch ergibt sich eine erhöhte Genauigkeit in Teilen des Messbereiches bei gleicher Anzahl an Vergleichern/Komparatoren 103.

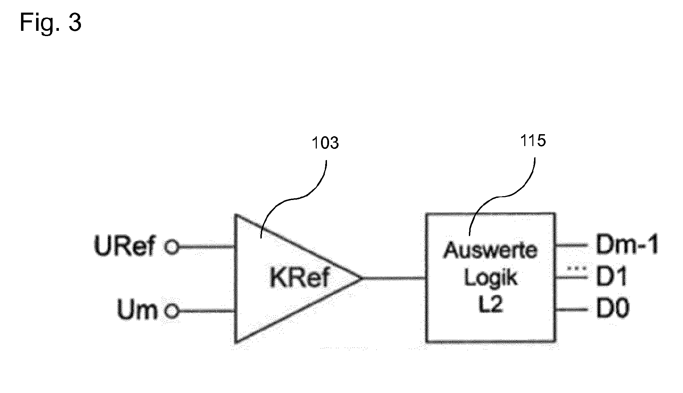

Fig. 3 zeigt einen Vergleicher 103 in Kombination mit einer Auswertelogik 115. Dem Vergleicher 103 wird der nichtlineare Spannungsverlauf Uref als Vergleichsgröße zugeführt, der mit der Eingangsgröße Um verglichen wird. Je nach Verhältnis dieser beiden Größen zueinander gibt der Vergleicher 103 ein unterschiedliches Signal aus, das an die Auswertlogik 115 übergeben wird. Am Ausgang des Vergleichers 103 steht somit ein Signal zur Verfügung, das anzeigt, welche der beiden Eingangsspannungen Uref oder Um höher ist. Die Auswertlogik erzeugt anschließend einen digitalen Ausgabewert D0, ..., Dm-1 aus dem Signal des Vergleichers 103.

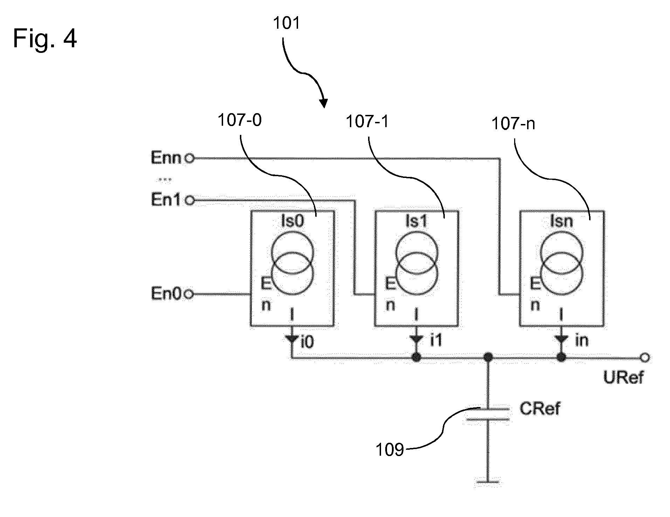

Fig. 4 zeigt eine Ansicht eines Referenzwerterzeugers 101. Der Referenzwerterzeuger 101 umfasst eine Anzahl von zuschaltbaren Stromblöcke 107-0,..., 107-n, die gemäß einen Eingangssignal zuschaltbar sind. Der Ausgang der Stromblöcke 107-0,..., 107-n ist mit einem Kondensator 109 verbunden. Die Stromblöcke 107-0,..., 107-n werden entsprechend dem Eingangssignal Enn derart an- und ausgeschaltet, dass sich ein nichtlinearer zeitlicher Referenzwertverlauf ergibt. Durch eine Überlagerung der Ströme, die nicht alle das gleiche Vorzeichen haben müssen, kann eine beliebige Kennlinie gefahren werden. Durch den Kondensator 109 wird ein nichtlinearer Referenzspannungsverlauf erzeugt.

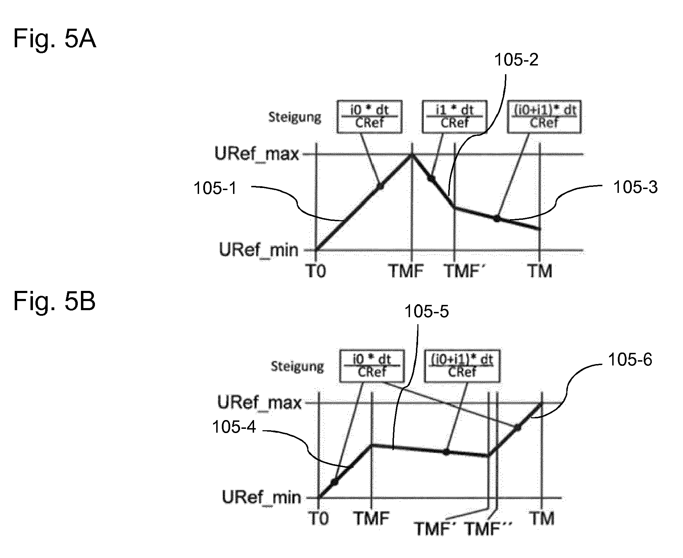

Fig. 5A zeigt eine Ansicht eines nichtlinearen Spannungsverlaufs 105, der aus den linearen Einzelabschnitten 105-1, 105-2 und 105-3 zusammengesetzt ist. Bei der Erzeugung eines Referenzwertverlaufs 105 als Spannungsverlauf kann auf eine strenge Monotonie des Verlaufs verzichtet werden, so dass der gesamte Messzeitraum hierfür sogar in mehrere Messbereiche unterteilt werden kann. Beispielsweise kann vorab vom Zeitpunkt T0 bis zum Zeitpunkt TMF in schneller Weise grob ein Messwert bestimmt werden. Zwischen den Zeitpunkten TMF und TM wird die vollständige aber nun genauere Wandlung abgeschlossen ist.

Fig. 5b zeigt eine weitere Ansicht eines nichtlinearen Spannungsverlaufs 105, der aus den linearen Einzelabschnitten 105-4, 105-5 und 105-6 zusammengesetzt ist. In dieser Ausführung ist ein beliebig gearteter Verlauf vorgesehen, der sich dadurch auszeichnet, dass dieser einen bestimmten Messbereich mehrfach überstreicht. Auf diese Weise kann beim erstmaligen Überstreichen das Messbereiches sehr schnell ein erster Messwert geliefert werden, während nach dem wiederholten Überstreichen dieses Messbereiches ein Wert mit einer verbesserten Genauigkeit geliefert werden kann. Hierzu wird bei jedem Überstreichen zwischen den Zeitpunkten TMF, TMF', ... , TMF" eine weitere Diskretisierung des Messwertes vorgenommen, so dass anschließend aus mehrerer dieser Messwerte ein einziger genaueren Messwert ermittelt werden kann.

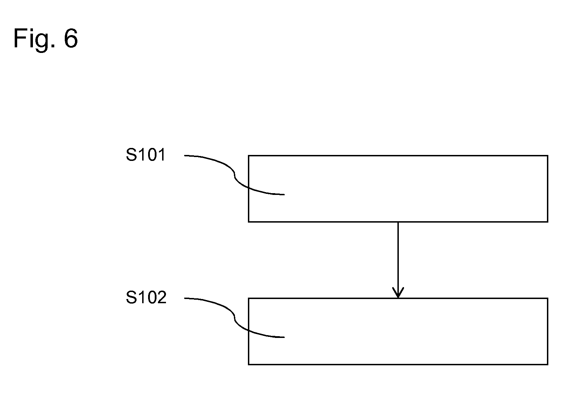

Fig. 6 zeigt ein Blockdiagram eines Verfahrens. Das Verfahren dient zum Wandeln eines analogen Eingabewertes in eine digitalen Ausgabewert, mit den Schritten eines Erzeugen S101 einer Anzahl von Referenzwerten mit einem nichtlinearen Verlauf durch einen Referenzwerterzeuger 101; und eines Vergleichen S103 eines Referenzwertes aus der Anzahl von Referenzwerten mit dem analogen Eingabewert durch einen Vergleicher 103, um den digitalen Ausgabewert zu erzeugen.

Alle in Verbindung mit einzelnen Ausführungsformen der Erfindung erläuterten und gezeigten Merkmale können in unterschiedlicher Kombination in dem erfindungsgemäßen Gegenstand vorgesehen sein, um gleichzeitig deren vorteilhafte Wirkungen zu realisieren.

Der Schutzbereich der vorliegenden Erfindung ist durch die Ansprüche gegeben und wird durch die in der Beschreibung erläuterten oder den Figuren gezeigten Merkmale nicht beschränkt.

### BEZUGSZEICHENLISTE

- 100: Wandler
- 101: Referenzwerterzeuger
- 103: Vergleicher
- 105: Spannungsverlauf
- 107: Stromblock
- 109: Kondensator
- 111: Widerstandsarray
- 113: Widerstand
- 115: Auswertelogik

## Patentansprüche

1. Elektrischer Wandler (100) zum Wandeln eines analogen Eingabewertes in eine digitalen Ausgabewert, mit:
- einem Referenzwerterzeuger (101) zum Erzeugen einer Anzahl von Referenzwerten mit einem nichtlinearen Verlauf; und
- einem Vergleicher (103) zum Vergleichen eines Referenzwertes aus der Anzahl von Referenzwerten mit dem analogen Eingabewert, um den digitalen Ausgabewert zu erzeugen.

2. Wandler (100) nach Anspruch 1, wobei der Referenzwerterzeuger (101) ausgebildet ist, einen zeitlich nichtlinearen Spannungsverlauf (105) zu erzeugen.

3. Wandler (100) nach Anspruch 2, wobei der Referenzwerterzeuger (101) ausgebildet ist, einen nicht-monotonen Spannungsverlauf (105-4) zu erzeugen.

4. Wandler (100) nach Anspruch 2 oder 3, wobei der Referenzwerterzeuger (101) ausgebildet ist, einen nichtlinearen Spannungsverlauf (105) aus zeitlich abschnittsweise linearen Spannungsverläufen (105-1, ..., 105-3) zu erzeugen.

5. Wandler (100) nach Anspruch 4, wobei ein linearer Spannungsverlauf (105-2) eine niedrigere Steigung als ein vorangehender linearer Spannungsverlauf (105-1) und ein nachfolgender Spannungsverlauf (105-3) aufweist.

6. Wandler (100) nach Anspruch 4, wobei ein Vorzeichen einer Steigung eines linearen Spannungsverlaufs (105-5) ein anderes Vorzeichen als eine Steigung eines vorangehenden linearen Spannungsverlaufs (105-4) und ein nachfolgenden Spannungsverlaufs (105-6) aufweist.

7. Wandler (100) nach einem der vorangehenden Ansprüche, wobei der Referenzwerterzeuger (101) mehrere zuschaltbare Stromblöcke (107-0,..., 107-n) umfasst.

8. Wandler (100) nach Anspruch 7, wobei die Stromblöcke (107-0,..., 107-n) gemäß einen Eingangssignal zuschaltbar sind.

9. Wandler (100) nach Anspruch 8, wobei der Ausgang der Stromblöcke (107-0,..., 107-n) mit einem Kondensator (109) verbunden ist.

10. Wandler (100) nach Anspruch 1, wobei der Referenzwerterzeuger (101) ein Widerstandsarray (111) umfasst.

11. Wandler (100) nach Anspruch 10, wobei die Widerstände (113-0, ...,113-n) des Widerstandsarrays (111) in Serie geschaltet sind.

12. Wandler (100) nach Anspruch 11, wobei zwischen zwei Widerständen (113-0, ...,113-n) jeweils ein Vergleicher (103-1, ..., 103-n) verbunden ist.

13. Verfahren zum Wandeln eines analogen Eingabewertes in eine digitalen Ausgabewert, mit:
- Erzeugen (S101) einer Anzahl von Referenzwerten mit einem nichtlinearen Verlauf durch einen Referenzwerterzeuger (101); und
- Vergleichen (S103) eines Referenzwertes aus der Anzahl von Referenzwerten mit dem analogen Eingabewert durch einen Vergleicher (103), um den digitalen Ausgabewert zu erzeugen.

14. Verfahren nach Anspruch 13, wobei der nicht lineare Verlauf (105) ein zeitlich nichtlinearer Spannungsverlauf ist.

15. Verfahren nach Anspruch 13 oder 14, wobei der nicht lineare Verlauf (105) ein nicht-monotoner Spannungsverlauf ist.
